# EUROPEAN PATENT APPLICATION

(11) **EP 4 345 866 A1**
(43) Date of publication of application: **03.04.2024**
(21) Application number: 22306426.2
(22) Date of filing: 27.09.2022
(51) Int. Cl.: H01L 21/60, H05K 1/18

(54) **A METHOD AND A SYSTEM FOR MANUFACTURING AN ASSEMBLY OF A POWER SEMICONDUCTOR**

(71) Applicant: Mitsubishi Electric R & D Centre Europe B.V., 1119 NS Schiphol Rijk (NL); MITSUBISHI ELECTRIC CORPORATION, Chiyoda-ku Tokyo 100-8310 (JP)
(72) Inventor: MORAND, Julien, 35700 RENNES (FR)
(74) Representative: Cabinet Le Guen Maillet

(57) **Abstract**

The present invention concerns a method for manufacturing a package of a power semiconductor and a package comprising a power semiconductor (200). The package comprises:
- conducting layers (240a,240b, 240c) over each electrode (250a,250b,250c) of the power semiconductor,
- nanowires (500a, 500b, 500c) over the part of the conducting layer that are over the electrodes,
- cured prepeg (700a, 700b) on each side of the power semiconductor and over (910b) a part of a masking film that separate two electrodes,
- conducting layers (110a, 110b)) over nanowires, the conducting layers over each electrode of the power semiconductor, the nanowires and the conducting layers over the nanowires forming a single conductor unit.

## Description

### TECHNICAL FIELD

The present invention relates generally to a method and a system for manufacturing an assembly of a power semiconductor in a package.

### RELATED ART

Classically a power semiconductor is electrically connected to external components via wire bonds, soldering and thermally in contact with a conductive substrate for the heat transport. A number of layers is necessary to enable the cabling of the wire bonds on the power semiconductor including, for example, an Aluminum metallization layer, a solder layer and a passivation layer.

When the assembly is subject to thermo-mechanical stress due to coefficient of thermal expansion mismatches and thermal gradient, the interconnection may be damaged, leading ultimately to the failure of the power semiconductor.

An alternative to wire bonding is to embed the power semiconductor into a Printed Circuit Board (PCB). The connections are made of laser drilled micro vias. Although the parasitic inductance of the connections is improved, the flexibility of the micro vias under thermal and mechanical stress is not optimal.

Soft interconnection composed of micro/nano copper wires are proposed in order to overcome the aforementioned problems. Nano wires have a high aspect ratio, meaning their height is many times bigger than their diameter. This form factor provides flexibility to deform under mechanical stress. They have relatively high density, forming a nano-wire forest, in order to effectively transfer current and heat.

The mechanical displacements due to thermal effects between the power semiconductor and the printed circuit board are absorbed throught deformation of the nano wires without damaging them. Copper Nano wires manufacturing methods may be performed by electrodeposition through a porous membrane acting as a template which is dissolved after the nano wires realization.

### SUMMARY OF THE INVENTION

The present invention aims to provide a manufacturing method and an assembly of a power semiconductor in a package which is very reliable and easy to implement and a package comprising a power semiconductor which is very robust against stress.

To that end, the present invention concerns a method for manufacturing a power semiconductor having electrodes in a package, the method comprising the steps of:
- disposing a masking film on the entire top and bottom surfaces of the power semiconductor and creating openings over the electrodes,
- disposing a conductive layer on the top and bottom surfaces of the masked power semiconductor,
- positionning templates over the electrodes of the power semiconductor and the nanowire,
- electro-depositing of a conducting material for nanowire formation over the electrodes of the power semiconductor, the nanowire formation being performed within the templates,
- removing the masking film and materials over the masking film,
- inserting the power semiconductor into a cavity of a prepeg panel,
- curing the prepeg panel,
- disolving the templates,
- deposing prepeg over the top and bottom of the cured prepeg panel and over a part of the power semiconductor which is between two electrodes metalizations,
- depositing a conductive layer on the surface of the deposed prepeg.
- curing the deposed prepeg.
- deposing conducting layers on the top and the bottom of the panel comprising at least one power semiconductor after the curing of the prepeg,
- etching the part of the conducting layer that is over the cured prepeg over the part of the power semiconductor between two electrodes metalizations.

Thus, high aspect ratio nanowire can be growed on each electrodes of the power semiconductor. The dimension of the nanowires is given by the pore dimensions of the membrane. Comparing to copper filled microvias, the elasticity of the nanowires is higher.

Furthermore, the nanowires are protected by the membrane during handling and moving steps. The membrane dissolution is realized at the last minute.

According to a particular feature, each template recovers the part of the conductive layer that is over the electrode and a part of the conductive layer that is over the masking film.

The present invention concerns also a package of a power semiconductor comprising :
- conducting layers over each electrode of the power semiconductor,
- nanowires over the part of the conducting layer that is over the electrodes,
- cured prepeg on each side of the power semiconductor and over a part of a masking film that separate two electrodes,
- conducting layers over nanowires, the conducting layers over each electrode of the power semiconductor, the nanowires and the conducting layers over the nanowires forming a single conductor unit.

Thus, the obtained structure is suited for enduring mechanical deformation while conducting current and heat.

According to a particular feature, the nanowires have a height that is between thirty to hundred times the width of a nanowire.

Thus, a flexible bond between the die and the package is realized despite different Coefficient of Thermal Expension (CTE) on the stackup.

According to a particular feature, the conducting layers over each electrode of the power semiconductor act as a thermal interface conducting the heat away from the power semiconductor.

Thus, the junction temperature of the power device is controlled.

According to a particular feature, the nanowires are made of an electrically and thermally conductive material such as Copper, Nickel, Aluminum, Silver, Gold or carbon or an alloy of the aforementioned materials.

Thus, an electrical link between the die and the power package is done.

According to a particular feature, the nanowires cover between 50 and 90 % of the electrodes surface.

### BRIEF DESCRIPTION OF THE DRAWINGS

The characteristics of the invention will emerge more clearly from a reading of the following description of example embodiments, the said description being produced with reference to the accompanying drawings, among which:
Fig. 1 represents an example of an algorithm for manufacturing an assembly of a power semiconductor in a package;
Fig. 2 represents an example of deposition of different layers on a power semiconductor;
Fig. 3 represents an enlarged view of a part of a power semiconductor with deposition of different layers on a power semiconductor;
Fig. 4 represents an example of templates depositions on a power semiconductor for nano wires realization;
Fig. 5 represents an example of nano wires on the power semiconductor;
Figs. 6 and 7 represent examples of the power semiconductor insertion in a printed circuit board;
Fig. 8 represents an example of the power semiconductor after templates removal;
Figs. 9 to 11 represent examples of the printed circuit board completion;
Fig. 12 represents an example of a device for manufacturing an assembly of a power semiconductor in a package.

### DESCRIPTION

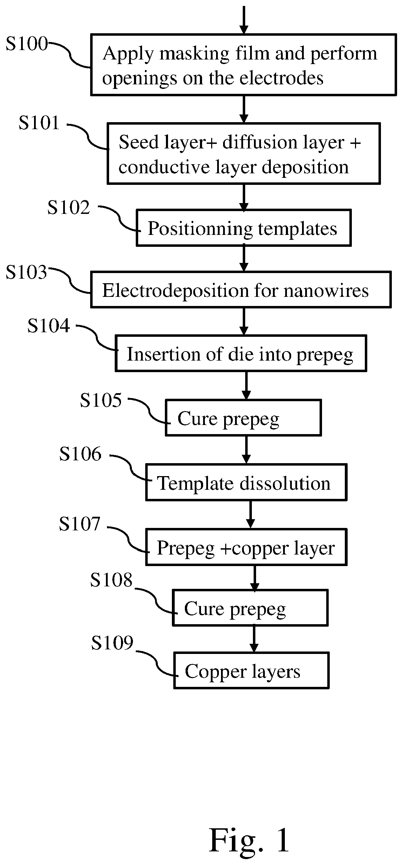

Fig. 1 represents an example of an algorithm for manufacturing an assembly of a power semiconductor in a package.

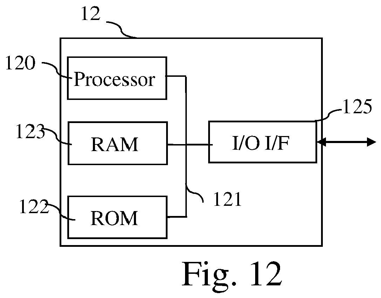

The present algorithm is for example executed by the processor 120 of the system 12 for manufacturing an assembly of a power semiconductor in a package as it will be disclosed in reference to Fig. 12.

At step S100, the processor 120 commands the deposition of a masking film on the entire top and bottom surfaces of the power semiconductor. For example, the masking mask is deposed on the top and bottom surfaces of a wafer which comprises the power semiconductor. At the same step, the processor 120 command the realization of openings over the surfaces of the top and/or bottom electrodes.

At step S101, the processor 120 commands successively the deposition of a seed layer, a diffusion barrier layer and a conductive layer on the top and bottom surfaces of the masked wafer. For proper compatibility with standard PCB process, the conductive layer is in general made of copper. The purpose of the conductive layer is to act as front-end distribution layer for the following process steps and will be peeledoff prior singulation.

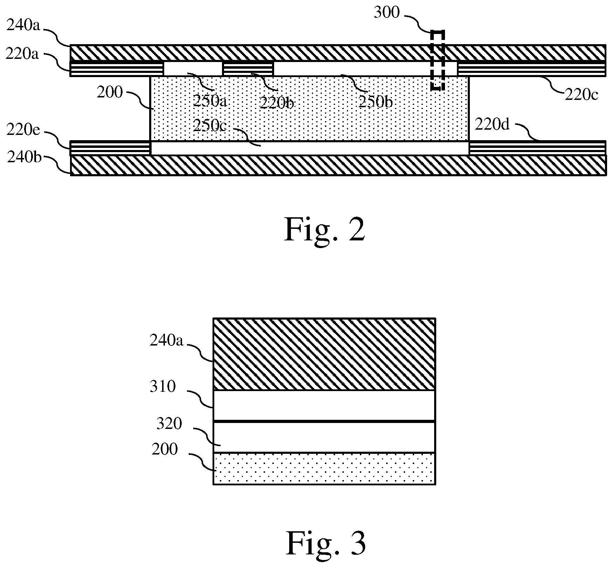

An example in given in reference to Fig. 2.

**Fig. 2** represents an example of deposition of different layers on a power semiconductor.

The power semiconductor 200 has at least three electrodes noted 250a, 250b and 250c.

The remaining parts of the masking film are noted 220a, 220b, 220c, 220d and 220e.

The conductive layers are noted 240a, 240b and 240c.

The part 220b of the masking film separates the electrodes 250a and 250b.

For the sake of simplification, the seed layers and the diffusion barrier are not shown in Fig. 2.

Fig. 3 represents an enlarged view of a part of a power semiconductor with deposition of different layers on the power semiconductor.

The enlarged view of the part of a power semiconductor noted 300 in Fig. 1 shows the power semiconductor 200 on which depositions of the seed layer 320 and the diffusion barrier layer 310 are performed.

At step S102, the processor 120 commands the positionning of templates over the electrode metallisations of the power semiconductor. The template 400a recovers the part of the conductive layer 240a that is over the electrode 250a and a part of the conductive layer that is over the masking film 220a and 220b. For example, the template 400a overlaps the masking films 220a and 220b by 200 micrometers.

The template 400b recovers the part of the conductive layer 240a that is over the electrode 250b and a part of the conductive layer that is over the masking film 220b and 220c. For example, the template 400b overlaps the masking films 220b and 220c by 200 micrometers.

The template 400c recovers the part of the conductive layer 240b that is over the electrode 250c and a part of the conductive layer that is over the masking film 220d and 220e. For example, the template 400c overlaps the masking films 220d and 220e by 200 micrometers.

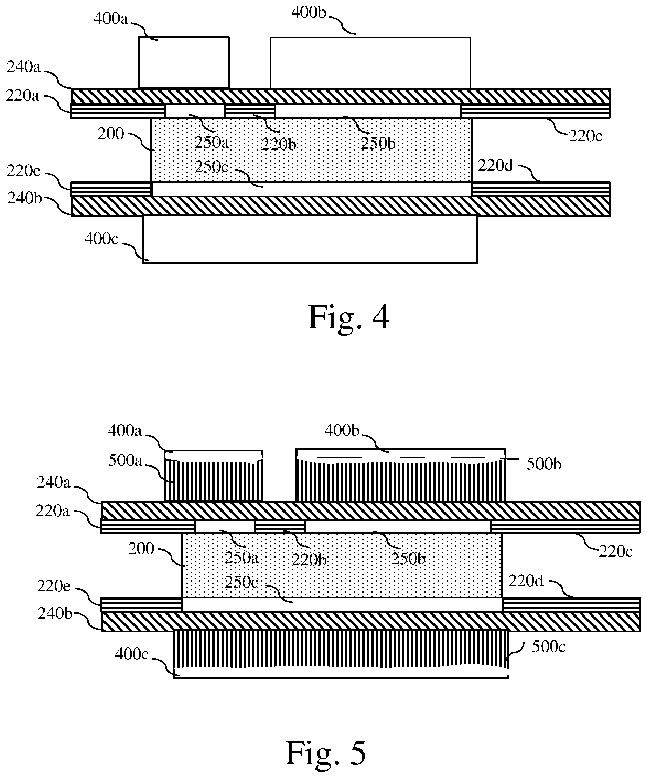

An example of the positioning of the templates is shown in Fig. 4.

**Fig. 4** represents an example of template depositions on a power semiconductor for nano wires realization.

The templates are noted 400a, 400b and 400c. The templates are for example AAO matrices that are clamped on top of the power seminconductor electrodes 250a, 250b and 250c on the whole wafer surface. The template is pressed on the wafer ensuring a good contact at the membrane to copper interface for priming the nanowire deposition. The surface of the template is generally larger than the power semiconductor electrode one. A sufficient margin is added to alleviate constraints on the accuracy of positioning.

At step S103, the processor 120 commands the process of electro deposition for nanowire formation.

The redistribution coper layers 240a and 240b are connected to one potential and are acting as the cathode in the reaction. A copper electrode (anode) is placed in the vicinity of the plated wafer. Both electrodes, wafer and anode, are submerged in an electrolytique bath. The growth of the nanowire is stopped before reaching the top of the template. Since the nanowire and the template are intricated, the clamping pressure can be released.

The nanowires have a height that is between thirty to hundred times the width of a nanowire.
The nanowires are made of an electrically and thermally conductive material such as Copper, Nickel, Aluminum, Silver, Gold or carbon or an alloy of the aforementioned materials.

An example is given in reference to Fig. 5.

**Fig. 5** represents an example of nano wires on the power semiconductor.

The nanowires 500a, 500b, 500c are shown in Fig. 5.

The photoresist film 220a to 220e and the materials above the photoresist film 220a to 220e are removed by lift-off technique revealing the power semiconductor with copper pads and the templates with nanowires stacked on top of each electrode of the power semiconductor. The singulation of the power semiconductor is operated using laser, or a blade. The templates act as protective case for the nanowire during handling of the die.

The nanowires cover between 50 and 90 % of the electrodes surface.

At step S104, one or several dies are force-inserted into a prepeg panel with a dedicated cavity each. The thickness of the uncured dielectric is similar to the power semiconductor one. Optionally, a dab of glue or a frame can be added to prevent the power semiconductor to fall from the cavity. A first lamination stage occurs with pressing plates made of non-stick material and with openings over the power semiconductor. During this first lamination, the prepeg flows in the interstice between the die and the cavity and mechanically attaches the power seminconductor to a panel of a printed circuit board. The PCB panel is now used as a holder for the power seminconductor on the whole remaining process.

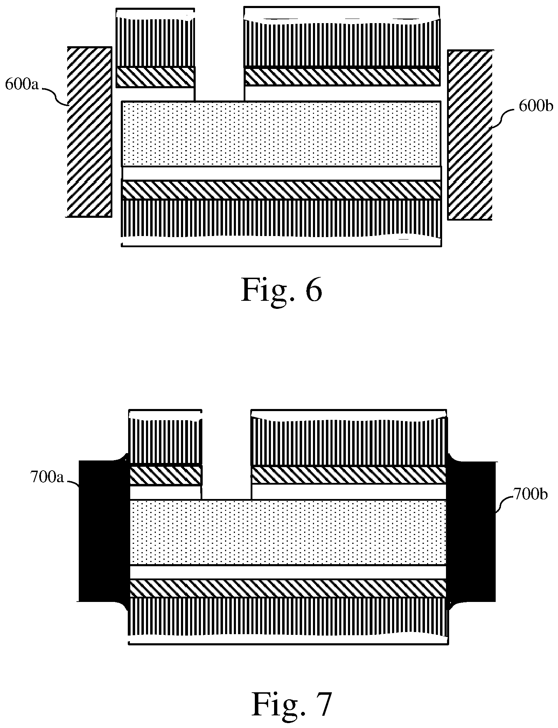

Example of the power semiconductor insertion into prepeg 600a 600b is shown in Fig. 6.

At step S105, the processor 120 commands to cure the prepeg.

Example of cured prepeg 700a and 700b is shown in Fig. 7.

At step S106, the processor 120 commands to dissolve the templates 400a, 400b and 400c.

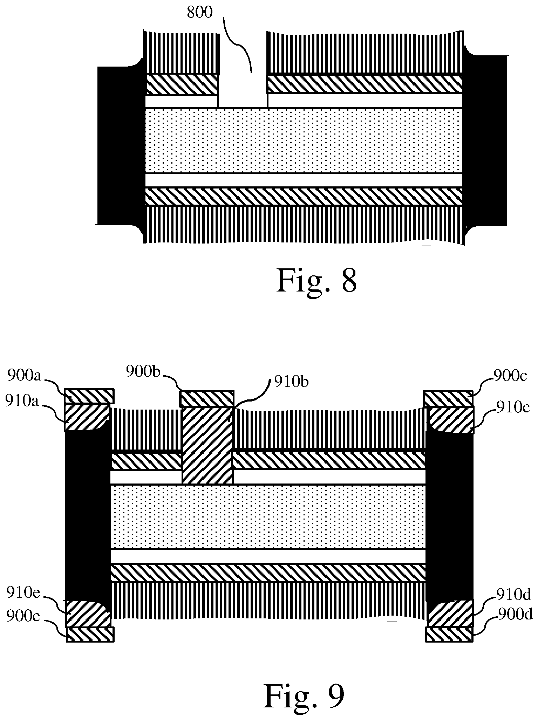

At this stage, the templates are dissolved to reveal the nanowire array as shown in Fig. 8.

A cavity 800 between electrodes is shown.

At step S107, the processor 120 commands the deposition of prepeg over the top and bottom of the cured prepeg 600a and 600b and in the cavity 800.

The prepeg layers are noted 910a, 910b, 910c, 910d and 910e are disposed over the cured prepeg 700a and 700b and in the cavity 800.

The processor 120 commands also the deposition of a conductive layer on the surface of the deposed prepeg.

Example is given in reference to Fig. 9.

The copper layers 900a, 900b, 900c, 900d and 900e have one or several openings on top of the electrodes. The area of the opening is slightly smaller than the nanowire one. The copper layers 900a, 900b, 900c, 900d and 900e are overlapping the outer rim of the nanowire array creating a narrow strip for electrical contact after lamination. The width of this strip is directly driven by the accuracy of positioning of the foil on the panel comprising at least one power semiconductor. Practically, a precision of 50 to 100 micrometers is foreseen.

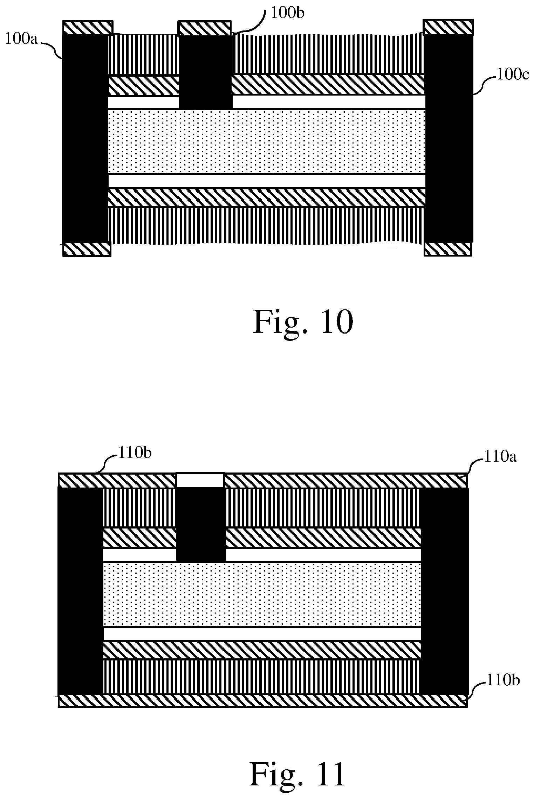

Fig. 10 discloses the panel comprising at least one power semiconductor after the curing at step S108 of the prepeg 910a, 910b, 910c, 910d and 910e. The cured prepeg 100a is the combination of the cured prepeg 700a and prepeg 910a and 910e. The cured prepeg 100b is the prepeg 910b after curing and the prepeg 100c is the combination of the cured prepeg 700b and the prepeg 910a and 910e.

At step S109, the processor 120 commands the electrodeposition of copper layers 110a and 110b on each side of the panel comprising at least one power semiconductor after curing the prepeg. The electrodeposition is now an over plating process where bridges of copper are connecting the tips of nanowire and form a continuous layer of copper combined with the initial copper layer.

The part of the copper layer that is over the cured prepeg 100b is etched.

The copper layers 110a, 110b and 110c are shown in Fig. 11.

The obtained two-layer PCB will continue to be manufacturing using standard PCB manufacturing steps resulting in a power module.

The present method enables the manufacturing of a package of a power semiconductor comprising :
- conducting layers over each electrode of the power semiconductor,
- nanowires over the part of the conducting layer that is over the electrodes,
- cured prepeg on each side of the power semiconductor and between two electrodes,
- conducting layers over nanowires, the conducting layers over each electrode of the power semiconductor, the nanowires and the conducting layers over the nanowires forming a single conductor unit.
The conducting layers over each electrode of the power semiconductor act as a thermal interface conducting the heat away from the power semiconductor.

**Fig. 12** represents an example of a device for manufacturing an assembly of a power semiconductor in a package.

The device 12 has, for example, an architecture based on components connected by a bus 121 and a processor 120 controlled by a program as disclosed in Fig. 1.

The bus 121 links the processor 120 to a read only memory ROM 122, a random access memory RAM 123, an input output I/O IF interface 125.

The input output I/O IF interface 125 enables the device 12 to control the different process of the manufacturing process.

The memory 123 contains registers intended to receive variables and the instructions of the program related to the algorithm as disclosed in Fig. 1.

The read-only memory, or possibly a Flash memory 122, contains instructions of the programs related to the algorithm as disclosed in Fig. 1, that are when the device 12 is powered on, loaded to the random-access memory 123. Alternatively, the program may also be executed directly from the ROM memory 122.

The process performed by the device 12 may be implemented in software by execution of a set of instructions or program by a programmable computing machine, such as a PC *(Personal Computer),* a DSP *(Digital Signal Processor)* or a microcontroller; or else implemented in hardware by a machine or a dedicated component, such as an FPGA *(Field-Programmable Gate Array)* or an ASIC *(Application-Specific Integrated Circuit).*

In other words, the device 12 includes circuitry, or a device including circuitry, causing the device 12 to perform the program related to the algorithm as disclosed in Fig. 1.

## Claims

1. A method for manufacturing a power semiconductor having electrodes in a package, the method comprising the steps of:
- disposing a masking film on the entire top and bottom surfaces of the power semiconductor and creating openings over the electrodes,
- disposing a conductive layer on the top and bottom surfaces of the masked power semiconductor,
- positionning templates over the electrodes of the power semiconductor and the nanowire,
- electro-depositing of a conducting material for nanowire formation over the electrodes of the power semiconductor, the nanowire formation being performed within the templates,
- removing the masking film and materials over the masking film,
- inserting the power semiconductor into a cavity of a prepeg panel,
- curing the prepeg panel,
- disolving the templates,
- deposing prepeg over the top and bottom of the cured prepeg panel and over a part of the power semiconductor which is between two electrodes metalizations,
- depositing a conductive layer on the surface of the deposed prepeg.
- curing the deposed prepeg.
- deposing conducting layers on the top and the bottom of the panel comprising at least one power semiconductor after the curing of the prepeg,
- etching the part of the conducting layer that is over the cured prepeg over the part of the power semiconductor between two electrodes metalizations.

2. The method according to claim 1, **characterized in that** each template recovers the part of the conductive layer that is over the electrode and a part of the conductive layer that is over the masking film.

3. A package of a power semiconductor comprising :
- conducting layers over each electrode of the power semiconductor,
- nanowires over the part of the conducting layer that are over the electrodes,
- cured prepeg on each side of the power semiconductor and over a part of a masking film that separate two electrodes,
- conducting layers over nanowires, the conducting layers over each electrode of the power semiconductor, the nanowires and the conducting layers over the nanowires forming a single conductor unit.

4. The package according to claim 3, **characterized in that** the nanowires have a height that is between thirty to hundred times the width of a nanowire.

5. The package according to claim 3 or 4, **characterized in that** the conducting layers over each electrode of the power semiconductor act as a thermal interface conducting the heat away from the power semiconductor.

6. The package according to claims 3 to 5, **characterized in that** the nanowires are made of an electrically and thermally conductive material such as Copper, Nickel, Aluminum, Silver, Gold or carbon or an alloy of the aforementioned materials.

7. The package according to claims 3 to 6, **characterized in that** the nanowires covers between 50 and 90 % of the electrodes surface.
